# EUROPEAN PATENT SPECIFICATION

(11) **EP 2 993 699 B1**
(45) Date of publication and mention of the grant of the patent: **21.03.2018**
(21) Application number: 14183484.6
(22) Date of filing: 04.09.2014
(51) Int. Cl.: H01L 31/18

(54) **Method for fabricating crystalline photovoltaic cells**
Verfahren zur Herstellung kristalliner photovoltaischer Zellen
Procédé de fabrication de cellules photovoltaïques cristallines

(43) Date of publication of application: 09.03.2016
(73) Proprietor: IMEC VZW, 3001 Leuven (BE)
(72) Inventor: Recaman Payo, Maria, 3001 Leuven (BE); Duerinckx, Filip, 3001 Leuven (BE); Aleman, Monica, 3001 Leuven (BE)
(74) Representative: Patent Department IMEC

(56) References cited:
- WO-A1-2013/020868
- US-B1- 8 642 378

## Description

### Field

The present disclosure is related to methods for fabricating crystalline photovoltaic cells, such as crystalline silicon photovoltaic cells.

### State of the art

Epitaxial growth of highly doped regions is a promising technique for the creation of emitter regions, Back Surface Field (BSF) regions and/or Front Surface Fields (FSF) regions of silicon photovoltaic cells. A high throughput for the epitaxial growth may be obtained by using for example an LPCVD (Low Pressure Chemical Vapour Deposition) system wherein the silicon substrates or wafers are loaded in batch-type substrate boats. In such high throughput systems, all substrate surfaces are exposed to the precursors used during epitaxial growth. Epitaxial growth occurs on all silicon surfaces exposed to the precursors. Therefore a masking step prior to epitaxy or a patterning step after epitaxy is needed if a local epitaxial layer pattern is needed or if an epitaxial layer is to be provided on a single substrate surface only.

In addition, surface passivation of the silicon surfaces not subjected to epitaxial growth is desired. Classical thermal oxidation (dry or wet) results in a high quality surface passivation but requires a high thermal budget, and all exposed surfaces, including the epitaxial layer surfaces, are oxidized. Oxidation of the epitaxial layer surfaces may be undesirable, for example if another, e.g. more suitable, passivation layer is needed on the epitaxial layer surfaces. Therefore either a masking step or a patterning step is needed in case of thermal oxidation. Alternatively a locally applied passivation layer may be used for passivating the silicon surfaces not subjected to epitaxial growth, but such layers often require additional process steps (e.g. annealing) to obtain a good surface passivation.

Document US 8 642 378 B1 discloses a method for forming a photovoltaic device, wherein a passivation dielectric layer is formed on the front side of a semiconductor substrate, and a doped epitaxial layer is afterwards grown on the backside of the substrate. The epitaxial growth is preferably performed at deposition temperature ranges from about 150°C to about 250°C.

Document WO 2013/020868 discloses a process for manufacturing Interdigitated Back Contact photovoltaic cells, wherein a doped dielectric layer is formed and patterned on the backside of a semiconductor substrate. This step is followed by selective epitaxial growth of a doped silicon layer having a doping type opposite to the doping type of the substrate, using the patterned doped dielectric layer as a mask for epitaxial growth. The selective epitaxial growth can be done preferably at a temperature in the range between 850°C and 950°C. During epitaxial deposition, a drive-in of dopants from the patterned doped dielectric layer into the substrate results in the formation of back surface field regions.

### Summary

The present disclosure aims to provide a method for fabricating good crystalline photovoltaic cells, such as crystalline silicon photovoltaic cells, wherein the number of process steps and/or the thermal budget is reduced as compared to known fabrication processes.

The present disclosure aims to provide a method for fabricating crystalline photovoltaic cells, such as crystalline silicon photovoltaic cells, wherein the number of process steps performed at a temperature exceeding 600°C is reduced as compared to known fabrication processes.

The present disclosure aims to provide a method for fabricating crystalline photovoltaic cells, such as crystalline silicon photovoltaic cells, with an improved performance as compared to similar cells fabricated using known fabrication processes.

The disclosure is related to a method for fabricating a crystalline semiconductor photovoltaic cell, according to independent claim 1.

In a method of the present disclosure, a surface passivation quality of the dielectric layer is improved as a result of the epitaxial layer growth, i.e. the surface passivation quality of the dielectric layer after epitaxial layer growth is better than the surface passivation quality of the as-deposited dielectric layer. An improved surface passivation quality results in a reduced surface recombination velocity.

The dielectric layer may be deposited at a temperature lower than 500°C, for example by Chemical Vapour Deposition (CVD), Atomic layer Deposition (ALD), pyrolithic coating, spin coating, spray coating or dip coating.

The dielectric layer comprises silicon oxide, silicon nitride, silicon carbide, oxynitride or titanium oxide.

The doped epitaxial layer is grown at a temperature in the range between 600°C and 1000°C. In some embodiments of the present disclosure the step of growing the doped epitaxial layer may be the only step in the photovoltaic cell fabrication process that is done at a temperature higher than 600°C. However, the present disclosure is not limited thereto and other steps in the photovoltaic cell fabrication process may be done at a temperature exceeding 600°C, such as for example a diffusion step e.g. for forming a Front Surface Field (FSF).

The thickness of the doped epitaxial layer may for example be in the range between 10 nm and 5 micrometer, the present disclosure not being limited thereto.

The doped epitaxial layer may form an emitter region, a Back Surface Field (BSF) region or a Front Surface Field (FSF) region of the photovoltaic cell.

In embodiments of the present disclosure, depositing the dielectric layer at the first predetermined locations may comprise depositing the dielectric layer at the first predetermined locations and at the second predetermined locations, followed by removing the dielectric layer from the second predetermined locations. In other embodiments of the present disclosure, depositing the dielectric layer at the first predetermined locations may comprise depositing the dielectric layer only at the first predetermined locations.

The first predetermined locations and the second predetermined locations may be present on opposite surfaces of the semiconductor substrate.

In a method of the present disclosure, the step of growing the doped epitaxial layer at the second predetermined locations may be done in a system wherein both semiconductor substrate surfaces are exposed to the precursors used during epitaxial growth. It is an advantage that such a system may have a high throughput.

It is an advantage of a method of the present disclosure that highly doped regions and good surface passivation layers may be formed simultaneously at different locations on a surface or on opposite surfaces of a semiconductor substrate, with a minimal thermal budget (i.e. requiring only a single high temperature step) and without the need for additional post-processing steps such as additional annealing steps for dopant activation or additional treatments (e.g. forming gas annealing) for improving the surface passivation quality.

In the context of the present disclosure, a high temperature step is a process step performed at a temperature of 600°C or higher.

A method of the present disclosure is used as part of a fabrication process for crystalline photovoltaic cells, e.g. crystalline silicon photovoltaic cells, for example for the simultaneous creation of emitter regions and good surface passivation layers at different locations, or for example for the simultaneous creation of Back Surface Field regions and good surface passivation layers at different locations.

It is an advantage of a method of the present disclosure that it allows fabricating good photovoltaic cells with less process steps as compared to known methods. A method of the present disclosure may lead to a lower photovoltaic cell processing cost due to the reduced number of process steps as compared to prior art processes.

A method of the present disclosure may also lead to an improved surface passivation of the non-epitaxial surfaces and thus to an improved photovoltaic cell efficiency as compared to prior art methods.

It is an advantage of a method of the present disclosure that it allows fabricating good photovoltaic cells with a lower thermal budget as compared to known methods. It is an advantage of a lower thermal budget that it leads to a reduced influence on doping profiles already present, i.e. a reduced dopant redistribution. It is an additional advantage of a lower thermal budget that it may reduce the risk of degradation of the substrate, i.e. it may reduce the risk of reduction of the minority carrier lifetime of the substrate.

In the context of the present disclosure, the thermal budget of a process step is the total amount of thermal energy transferred to the substrate during the process step, e.g. high temperature step. It is proportional to the temperature and the duration of the process step.

Certain objects and advantages of various inventive aspects have been described herein above. Of course, it is to be understood that not necessarily all such objects or advantages may be achieved in accordance with any particular embodiment of the disclosure. Thus, for example, those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure. The disclosure, both as to organization and method of operation, together with features and advantages thereof, may best be understood by reference to the following detailed description when read in conjunction with the accompanying drawings.

### Brief description of the figures

FIG 1 schematically shows a cross section of an n-type rear junction photovoltaic cell that may be fabricated using a method of the present disclosure.
FIG 2 shows process steps for fabricating an n-type rear junction photovoltaic cell using a method in accordance with the present disclosure.
FIG 3 schematically shows a cross section of a p-type PERC (Passivated Emitter and Rear Contact) cell that may be fabricated using a method not being part of the present invention.
FIG 4 shows process steps for fabricating a p-type PERC cell using a method not being part of the present invention.

Any reference signs in the claims shall not be construed as limiting the scope of the present disclosure.

In the different drawings, the same reference signs refer to the same or analogous elements.

### Detailed description

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure.

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

In the context of the present disclosure, the front surface or front side of a photovoltaic cell is the surface or side adapted for being oriented towards a light source and thus for receiving illumination. In case of bifacial photovoltaic cells, both surfaces are adapted to receive impinging light. In such case, the front surface or front side is the surface or side adapted for receiving the largest fraction of the light or illumination. The back surface, back side, rear surface or rear side of a photovoltaic cell is the surface or side opposite to the front surface. The front side of a substrate used to form a photovoltaic cell is the side of the substrate corresponding to the front side of the photovoltaic cell, while the rear side or back side of the substrate corresponds to the back side of the photovoltaic cell.

A method is provided for forming a good surface passivation layer at first predetermined locations on a surface of a semiconductor substrate and for depositing an epitaxial layer at second predetermined locations on a surface of the semiconductor substrate, the second predetermined locations being different from the first predetermined locations, wherein the method only requires a single high temperature step, being the epitaxial layer deposition step. The first predetermined locations and the second predetermined locations are non-overlapping.

A method according to the present disclosure is used in a fabrication process for crystalline photovoltaic cells. A method for fabricating a photovoltaic cell in accordance with the present disclosure comprises: depositing a dielectric layer at first predetermined locations on a surface of a semiconductor substrate; and afterwards growing a doped epitaxial layer at second predetermined locations on a surface of the semiconductor substrate, the second predetermined locations being different from and non-overlapping with the first predetermined locations, wherein the dielectric layer is maintained as a surface passivation layer in the photovoltaic cell, i.e. the dielectric layer remains on the surface of the semiconductor substrate during further fabrication of the photovoltaic cell.

In a method of the present disclosure, the doped epitaxial layer may contain the same semiconductor material as the semiconductor substrate. For example, in embodiments of the present disclosure the semiconductor substrate and the epitaxial layer may be crystalline silicon layers. However, the present disclosure is not limited thereto: other semiconductor materials may be used and the epitaxial layer may contain a semiconductor material different from the material of the semiconductor substrate.

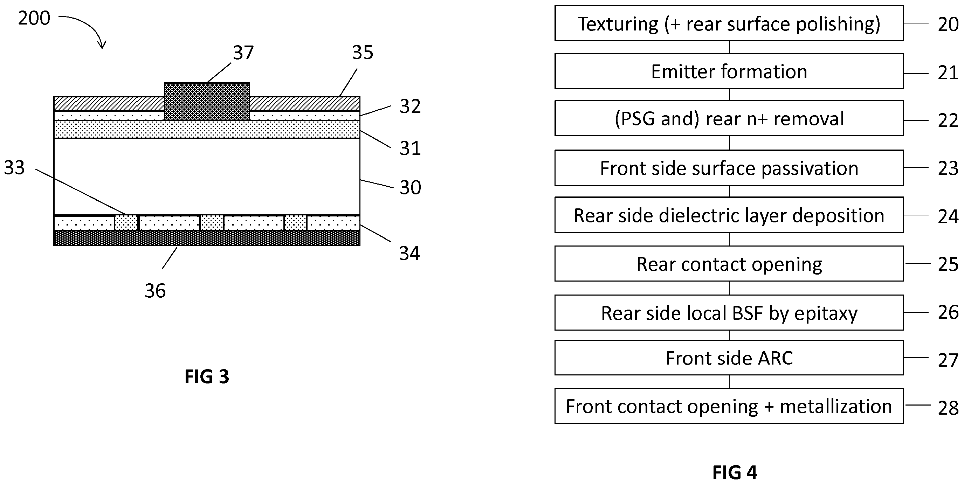

In an example not being part of the present invention, the first predetermined locations and the second predetermined locations may be adjacent to each other on a same substrate surface. An example of such an embodiment is further illustrated in FIG 3 and FIG 4. This example shows a fabrication process of a p-type PERC cell wherein the second predetermined locations correspond to local Back Surface Field regions at the rear side of the cell and wherein the first predetermined locations correspond to passivated regions at the rear side of the cell, at locations complementary to the Back Surface Field regions.

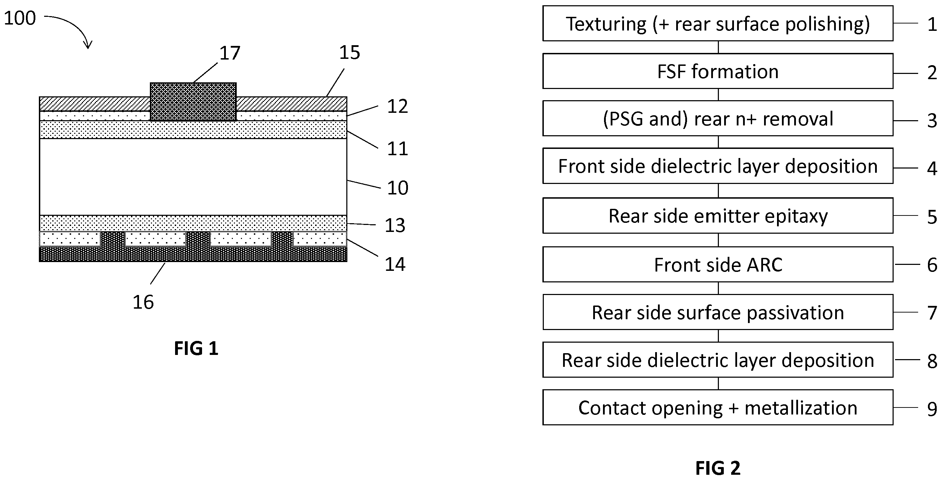

In embodiments of the present invention, the first predetermined locations and the second predetermined locations are on opposite surfaces of the substrate. An example of such an embodiment is further illustrated in FIG 1 and FIG 2. This example shows a fabrication process for an n-type rear junction photovoltaic cell wherein the first predetermined locations correspond to the front side of the cell and wherein the second predetermined locations correspond to rear side of the cell. This is only an example, and the present disclosure is not limited thereto.

In examples not being part of the present invention, the first predetermined locations may be present at both substrate surfaces. An example is a fabrication process for a p-type PERC cell (FIG 3) wherein the second predetermined locations correspond to a local Back Surface Field region at the rear side of the cell and wherein the first predetermined locations correspond (a) to passivated regions at the rear side of the cell, complementary to the Back Surface Field regions and (b) to the front side of the cell.

In other examples not being part of the present invention, the second predetermined locations may be present at both substrate surfaces. An example is a fabrication process for an n-type Interdigitated Back Contact cell wherein the second predetermined locations correspond (a) to the front side of the cell (Front Surface Field) and (b) to local Back Surface Regions at the rear side of the cell, and wherein the first predetermined locations correspond to passivated regions at the rear side of the cell, complementary to the Back Surface Field regions. This is only an example, and the present disclosure is not limited thereto.

Depositing the dielectric layer at the first predetermined locations may for example be done by CVD (Chemical Vapour Deposition, such as APCVD (Atmospheric Pressure CVD), PECVD (Plasma Enhanced CVD) or LPCVD (Low Pressure CVD), by ALD (Atomic layer Deposition), pyrolithic coating, spin coating, spray coating or dip coating. The dielectric layer may for example comprise or consist of SiOₓ, SiNₓ, SiCₓ, SiOₓN_{y} or TiOₓ, the present disclosure not being limited thereto.

The doped epitaxial layer may be an emitter region, a Back Surface Field region or a Front Surface Field region of the photovoltaic cell.

In examples not being part of the present invention, the epitaxial layer and the dielectric layer may be provided on a same surface of the semiconductor substrate. In such embodiments the step of growing the doped epitaxial layer is a selective epitaxial growth step wherein the dielectric layer functions as a masking layer for the epitaxial growth and wherein the epitaxial layer is grown at exposed locations on the surface of the semiconductor substrate. When in such embodiments the epitaxial growth is done in a reactor wherein both substrate surfaces are exposed to the precursors used for epitaxial growth, the surface of the substrate opposite to the surface where the dielectric layer and the epitaxial layer are provided may be masked, e.g. covered by a masking layer such as a dielectric layer, for preventing epitaxial growth on that surface.

In embodiments of the present disclosure the epitaxial layer and the surface passivation layer are provided on opposite surfaces of the semiconductor substrate. When in such embodiments the epitaxial growth is done in a reactor wherein both substrate surfaces are exposed to the precursors used for epitaxial growth, the dielectric layer on a surface functions as a masking layer for the epitaxial growth on that surface.

It was surprisingly found that the surface passivation quality of the deposited dielectric layer, e.g. PECVD or APCVD silicon oxide layer, is substantially improved during the epitaxial growth step. For example, an experiment was done with a two-side textured n-type silicon test wafer. At both sides of the wafer a Front Surface Field region with a sheet resistance of 175 Ohm per square was formed, and a PECVD silicon oxide layer was deposited on both wafer surfaces (front surface and rear surface). On this test wafer an effective lifetime of 76 microseconds was measured. Next, the test wafer was subjected to a temperature profile (thermal budget) corresponding to epitaxial growth at 950°C, as would be used in a photovoltaic cell fabrication process for forming e.g. an emitter region. This resulted in an effective lifetime of 1.78 milliseconds. This substantial increase in effective lifetime can be attributed to a substantial increase of the surface passivation quality of the dielectric layer.

The epitaxial growth is done at a temperature in the range between 600°C and 1000°C, e.g. between 800°C and 950°C, with a growth rate in the range between 5 nm/min and 1000 nm/min, e.g. in the range between 25 nm/min and 200 nm/min. The epitaxial layer thickness may be for example in the range between 10 nm and 5 micrometer, e.g. between 50 nm and 3 micrometer, the present disclosure not being limited thereto. Examples of precursors that may be used during epitaxial growth are SiH₄, DCS (dichlorosilane), TCS (trichlorosilane), H₂ and HCl for (selective) silicon growth and AsH₃, PH₃, BCl₃, B₂H₆ for doping the epitaxial layer. However, the present disclosure is not limited thereto and other suitable precursors known to a person skilled in the art may be used.

It is an advantage of a method of the present disclosure that only a single high temperature step (i.e. epitaxy) is needed to create a good surface passivation layer at first predetermined locations and a doped layer at second predetermined locations.

An example of a silicon photovoltaic cell 100 that may advantageously be fabricated using a method of the present disclosure is schematically shown in FIG 1. The photovoltaic cell 100 shown in FIG 1 is an n-type rear junction cell. It comprises an n-type silicon substrate 10 as a base region, and a blanket p⁺ doped emitter region 13 on the rear surface of the substrate 10. At the front surface a Front Surface Field (FSF) 11 is present for shielding minority carriers from the surface. This FSF requires a good front side passivation layer 12 to minimize surface recombination in this area. The cell further comprises at the front side an antireflection coating 15 and a front side contact 17. At the rear side a rear side dielectric layer or dielectric layer stack 14 is present, as well as a rear side contact 16. The rear side dielectric layer 14 may be a single layer or it may be a stack of at least two layers. Preferably the rear side dielectric layer 14 is a stack comprising a surface passivation layer and at least one additional rear side dielectric layer covering the surface passivation layer, the at least one additional rear side dielectric layer being provided for improving rear side reflection and for preventing metal spiking. The photovoltaic cell 100 is shown in FIG 1 with a non-textured front surface, but in advantageous embodiments the front surface may be textured.

A method for fabricating the photovoltaic cell of FIG 1 in accordance with a method of the present disclosure is schematically shown in FIG 2.

In a first step 1 the front surface of a silicon substrate 10 is textured, for example by etching in a KOH solution, a NaOH solution, a TMAH solution, a HF/HNO₃/CH₃COOH solution or by plasma texturing. The texturing may be a single side texturing step, wherein the rear side may be masked during texturing, or it may be a double side texturing step. In the latter case the texturing may be followed by a rear surface polishing step. In the example described here, the silicon substrate 10 is an n-type crystalline silicon substrate, for example with a resistivity in the range between 2 Ohm cm and 15 Ohm cm, the present disclosure not being limited thereto.

Next, in step 2, an n⁺ Front Surface Field (FSF) region 11 is formed at the front side of the substrate 10. The FSF may for example be formed by POCl₃ diffusion. Examples of other methods that may be used for forming the FSF are diffusion from a doped dielectric layer or from a doped spin-on or spray-on source or from a dopant containing paste, epitaxial growth, laser doping or ion implantation, the present disclosure not being limited thereto. In the example shown in FIG 1 the FSF extends over the entire front surface of the cell. However, the present disclosure is not limited thereto, and the FSF may for example be a local FSF that may e.g. be present only at the location of the front side contacts 17.

Next (step 3), in the example wherein the FSF is formed by POCl₃ diffusion, the PhosphoSilicate Glass (PSG) formed during the POCl₃ diffusion step at both sides of the substrate 10 and the n⁺ layer formed at the rear side of the substrate 10 as a result of the POCl₃ diffusion step are removed. The PSG may for example be removed in a HF/HCl solution. The n⁺ layer formed at the rear side may be removed by (single side) silicon etching, e.g. based on HF/HNO₃ chemistry, the present disclosure not being limited thereto.

At step 4, a dielectric layer 12 such as for example a silicon oxide layer, a silicon nitride layer, a silicon carbide layer, an oxynitride layer or a titanium oxide layer is deposited on the front surface of the substrate, for example by PECVD, for example with a thickness in the range between 5 nm and 120 nm, e.g. between 20 nm and 50 nm, the present disclosure not being limited thereto.

Step 5 comprises growing a p-doped epitaxial layer (doping concentration e.g. in the range between 10¹⁸ at/cm³ and 5.10²⁰ at/cm³) on the entire rear surface of the substrate 10, thereby forming a rear side emitter region 13 of the photovoltaic cell. The thickness of the p-doped epitaxial layer 13 may for example be in the range between 10 nm and 2 micrometer, the present disclosure not being limited thereto. During this epitaxial growth, the front side dielectric layer 12 not only prohibits epitaxial growth on that side of the substrate but it is also exposed to the elevated temperature during the epitaxial step, thereby improving the surface passivation quality of the dielectric layer and transforming the front side dielectric layer into a high quality passivation layer providing a good surface passivation quality.

The epitaxial growth is followed by the deposition of an antireflection coating (ARC) 15, such as for example a silicon nitride layer, at the front side (step 6) and the deposition of a rear side surface passivation layer (step 7), for example comprising depositing an Al₂O₃ passivation layer. Next (step 8), an additional rear side dielectric layer is deposited, such as for example a PECVD silicon oxide, silicon nitride, oxynitride or silicon carbide layer, on the rear side surface passivation layer. The stack of the rear side passivation layer and the additional rear side dielectric layer is shown in FIG 1 as a single layer 14.

Finally, in step 9, contact openings are formed (e.g. by laser ablation or another patterning technique) at the front side through the antireflection coating 15 and the font side passivation layer 12, thereby locally exposing the Front Surface Field region 11, and at the rear side through dielectric layer stack 14, thereby locally exposing the rear side emitter region 13. After the formation of the contact openings a metallization step is done for providing front side metal contacts 17 to the Front Surface Field Region 11 and rear side metal contacts 16 to the rear side emitter region 13.

In the example shown in FIG 1 and FIG 2 the dielectric layer 12 is deposited at first predetermined locations, wherein the first predetermined locations correspond to the front surface of the substrate 10. The doped epitaxial layer 13 is grown at second predetermined locations, wherein the second predetermined locations correspond to the rear surface of the substrate 10. Therefore, in this example, the first predetermined locations and the second predetermined locations are located on opposite surfaces of the substrate. If the epitaxial deposition is done in an environment where both substrate surfaces are exposed to the precursors used during epitaxial growth, the dielectric layer 12 at the front side acts as a masking layer for the epitaxial growth.

In the photovoltaic cell the dielectric layer 12 functions as a good front surface passivation layer. This layer can be retained in the photovoltaic device.

Experiments were done wherein n-type Cz-Si test wafers were prepared to test the passivation quality of a PECVD SiOₓ layer (corresponding to dielectric layer 12). Towards this end, a FSF region was formed at both sides of textured wafers, followed by Phosphosilicate Glass (PSG) removal and deposition of a PECVD SiOₓ layer on both wafer surfaces, to end up with a symmetrical device. Subsequently, the wafers were exposed to the thermal budget corresponding to the epitaxy without any actual epitaxial growth.

Photoluminescence and QSSPC (Quasi Steady State Photo Conductance) measurements were used to quantify the passivation quality of the FSF/passivation combination. It was surprisingly found that the approach of the present disclosure results in very low surface recombination current densities (lower than 10 fA/cm²), lower than recombination current densities obtained for similar test wafers with a combination of a FSF and a thermal oxide as a passivation layer (30-60 fA/cm²). Besides the excellent surface passivation obtained, these improved recombination current densities may also be related to a reduced drive-in of the FSF dopants due to a reduced thermal budget, and thus a stronger field near the wafer surfaces.

Large area (12.5 cm x 12.5 cm) n-Si rear junction photovoltaic cells 100 were made according to the method illustrated in FIG 2 and described above. For a first group of cells the rear surface, on which the epitaxial growth occurs, was chemically polished. For a second group of cells the rear surface was textured. The front side metallization 17 was done using an integrated Ni/Cu/Ag plating sequence. The rear side dielectric stack 14 consisted of an ALD-Al₂O₃ surface passivation layer thickened by a PECVD SiOₓ layer. The rear side metallization 16 was provided by A1 sputtering. The following average characteristics for small cell batches (about 7 cells per group) were measured: an average cell efficiency of 20.0% for the cells with a textured rear surface (second group) and an average cell efficiency of 20.3% for cells with a polished rear surface (first group). For the second group the average short-circuit current density J_{sc} was 38.6 mA/cm², the average open-circuit voltage V_{oc} was 654 mV and the average fill factor FF was 79.1%. For the first group the average J_{sc} was 38.9 mA/cm², the average Voc 658 mV and the average FF 79.5%.

It is an advantage of the process described above and schematically shown in FIG 2 that the rear side passivation and the front side passivation can be optimized independently, i.e. a good surface passivation layer is formed at the n-doped front side and a different optimized surface passivation layer (such as e.g. an Al₂O₃ layer) may be provided at the p-doped rear side. If thermal oxidation would be used for the front side passivation, this would require an additional etching step for removing the thermal oxide from the rear surface.

As illustrated above, using a method according to the present disclosure, a good surface passivation on one side of the cell can be combined with the creation of an epitaxial emitter on the opposite side of the device with a limited number of steps and with only a single step at high temperature. This avoids the need for any additional masking steps, or dopant activation steps, or additional annealing steps.

A method not being part of the present invention may also be used for forming a good surface passivation layer at first predetermined locations on a surface of a semiconductor substrate and for forming an epitaxial layer at second predetermined locations on the same surface of the semiconductor substrate, the second predetermined locations being different from and non-overlapping with the first predetermined locations.

An example of a photovoltaic cell 200 that may be fabricated using said methods, with the first predetermined locations and the second predetermined locations at the same substrate side, is shown in FIG 3. The cell 200 shown in FIG 3 is a p-Si PERC-type cell fabricated on a p-type silicon substrate 30. It comprises a local Back Surface Field (BSF) region 33 that is epitaxially grown at second predetermined locations on the rear surface of the substrate 30. The remaining rear side surface is passivated by a low quality APCVD or PECVD SiOₓ layer, transformed during the epitaxial step into a high quality passivating layer 34. The cell 200 further comprises at the front side an emitter region 31, a front surface passivation layer 32, an antireflective coating 35 and a front side contact 37. At the rear side a rear side contact 36 is provided.

A method for fabricating the photovoltaic cell 200 of FIG 3 in accordance with a method not being part of the present invention is schematically shown in FIG 4.

In a first step 20 the front surface of a silicon substrate 30 is textured, for example by etching in a KOH solution, a NaOH solution, a TMAH solution, a HF/HNO₃/CH₃COOH solution or by plasma texturing. The texturing may be a single side texturing step, wherein the rear side may be masked during texturing, or it may be a double side texturing step without masking. In the latter case the texturing may be followed by a rear surface polishing step. In the example described here, the silicon substrate 30 is an p-type crystalline silicon substrate, for example with a resistivity in the range between 0.2 Ohm cm and 10 Ohm cm, the present disclosure not being limited thereto.

Next, in step 21, an n-type emitter region 31 is formed at the front side of the substrate 30. The emitter region 31 may for example be formed by POCl₃ diffusion. Examples of other methods that may be used for forming the emitter region are diffusion from a doped dielectric layer or from a doped spin-on or spray-on source or from a dopant containing paste, epitaxial growth, laser doping or ion implantation, the present disclosure not being limited thereto.

Next (step 22), in the example wherein the emitter region is formed by POCl₃ diffusion, the PhosphoSilicate Glass (PSG) formed during the POCl₃ diffusion step at both sides of the substrate 30 and the n⁺ layer formed at the rear side of the substrate 30 as a result of the POCl₃ diffusion step are removed. The PSG may for example be removed in a HF/HCl solution. The n⁺ layer formed at the rear side may be removed by (single side) silicon etching, e.g. based on HF/HNO₃ chemistry, the present disclosure not being limited thereto.

At step 23 a surface passivation layer 32 such as for example a silicon oxide layer is provided on the front surface of the substrate, for example with a thickness in the range between 5 nm and 120 nm, e.g. between 20 nm and 50 nm, the present disclosure not being limited thereto. In embodiments of the present disclosure, the front side surface passivation layer 32 may for example be a thermal oxide layer. In other embodiments, the front side surface passivation layer 32 may be a deposited silicon oxide layer, for example a PECVD silicon oxide layer, wherein the surface passivation quality of this layer is improved during the epitaxial growth further in the process sequence.

At step 24, a dielectric layer 34 such as for example a silicon oxide layer, a silicon nitride layer, a silicon carbide layer, an oxynitride layer or a titanium oxide layer, is deposited on the rear surface of the substrate 30, for example by PECVD, for example with a thickness in the range between 40 nm and 500 nm, e.g. between 75 nm and 200 nm, the present disclosure not being limited thereto. This is followed by rear contact opening (step 25), for example by laser ablation, resulting in a patterned dielectric layer 34 at first predetermined locations, with openings at the locations (second predetermined locations) where a BSF region is to be formed.

Step 26 comprises growing a p⁺-doped epitaxial layer (doping concentration e.g. in the range between 10¹⁸ at/cm³ and 5.10²⁰ at/cm³) on the rear surface of the substrate 30, thereby using the patterned dielectric layer 34 as a mask and forming local BSF regions 33. The thickness of the p⁺-doped epitaxial layer 33 may for example be in the range between 10 nm and 5 micrometer, e.g. between 50 nm and 3 micrometer, the present disclosure not being limited thereto. During this epitaxial growth, the rear side dielectric layer 34 not only prohibits epitaxial growth at the first predetermined locations but it is also exposed to the elevated temperature during the epitaxial step, thereby transforming the rear side dielectric layer 34 into a high quality dielectric layer providing a good surface passivation quality. Epitaxial growth at the front side is prohibited by the front side surface passivation layer 32 provided in step 23. In embodiments wherein the front side surface passivation layer 32 is a deposited layer, such as for example a PECVD SiOₓ layer (similar to layer 34), the elevated temperature to which it is exposed during the epitaxial growth step may improve the surface passivation quality of this PECVD SiOₓ layer 32.

The epitaxial growth is followed by the deposition of an antireflection coating (ARC) 35, such as for example a silicon nitride layer, at the front side (step 27). Finally, in step 28, contact openings are formed (e.g. by laser ablation or another patterning technique) at the front side, followed by a metallization step to provide front side metal contacts 37 to the emitter region 31 and rear side metal contacts 36 to the rear side BSF regions 33.

The foregoing description details certain embodiments of the disclosure. It will be appreciated, however, that no matter how detailed the foregoing appears in text, the disclosure may be practiced in many ways. It should be noted that the use of particular terminology when describing certain features or aspects of the disclosure should not be taken to imply that the terminology is being re-defined herein to be restricted to including any specific characteristics of the features or aspects of the disclosure with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the invention.

## Claims

1. A method for fabricating a crystalline semiconductor photovoltaic cell (100, 200), the method comprising:
depositing a dielectric layer (12, 34) at first predetermined locations on a surface of a semiconductor substrate (10, 30), wherein the dielectric layer (12, 34) comprises silicon oxide, silicon nitride, silicon carbide, oxynitride or titanium oxide; and
afterwards growing a doped epitaxial layer (13, 33) at second predetermined locations on a surface of the semiconductor substrate (10, 30) the second predetermined locations being different from and non-overlapping with the first predetermined locations,
wherein the dielectric layer (12, 34) remains on the surface of the semiconductor substrate during fabrication of the photovoltaic cell (100, 200) and is maintained as a surface passivation layer of the crystalline semiconductor photovoltaic cell (100, 200),
**characterized in that**
growing the doped epitaxial layer (13, 33) is done at a temperature in the range between 600°C and 1000°C;
growing the doped epitaxial layer (13, 33) thereby improves a surface passivation quality of the dielectric layer (12, 34); and
first predetermined locations and second predetermined locations are present on opposite surfaces of the semiconductor substrate (10, 30).

2. The method according to claim 1 wherein the dielectric layer (12, 34) is deposited at a temperature lower than 500°C.

3. The method according to any of the previous claims wherein depositing the dielectric layer (12, 34) at the first predetermined locations comprises depositing the dielectric layer by Chemical Vapour Deposition, Atomic layer Deposition, pyrolytic coating, spin coating, spray coating or dip coating.

4. The method according to any of the previous claims wherein the doped epitaxial layer (13, 33) forms an emitter region, a back surface field region and/or a front surface field region of the photovoltaic cell (100, 200).

5. The method according to any of the previous claims wherein depositing the dielectric layer (12, 34) at the first predetermined locations comprises depositing the dielectric layer at the first predetermined locations and at the second predetermined locations, followed by removing the dielectric layer from the second predetermined locations.

6. The method according to any of the previous claims wherein growing the doped epitaxial layer (13, 33) at the second predetermined locations is done in a system wherein both semiconductor substrate surfaces are exposed to precursors used during epitaxial growth.

## Patentansprüche

1. Verfahren zur Herstellung einer kristallinen Halbleiter-Solarzelle (100, 200), wobei das Verfahren umfasst:
Aufbringen einer dielektrischen Schicht (12, 34) an ersten vorbestimmten Stellen auf einer Oberfläche eines Halbleitersubstrats (10, 30), wobei die dielektrische Schicht (12, 34) Siliziumoxid, Siliziumnitrid, Siliziumcarbid, Oxynitrid oder Titanoxid umfasst; und
anschließend Züchtung einer dotierten Epitaxialschicht (13, 33) an zweiten vorbestimmten Stellen auf einer Oberfläche des Halbleitersubstrats (10, 30), wobei sich die zweiten vorbestimmten Stellen von den ersten vorbestimmten Stellen unterscheiden und sich nicht mit diesen überschneiden,
wobei die dielektrische Schicht (12, 34) während der Herstellung der Solarzelle (100, 200) auf der Oberfläche des Halbleitersubstrats verbleibt und als Oberflächen-Passivierungsschicht der kristallinen Halbleiter-Solarzelle (100, 200) gehalten wird,
**dadurch gekennzeichnet, dass**
die Züchtung der dotierten Epitaxialschicht (13, 33) bei einer Temperatur im Bereich zwischen 600°C und 1000°C erfolgt;
die Züchtung der dotierten Epitaxialschicht (13, 33) somit die Qualität einer Oberflächen-Passivierung der dielektrischen Schicht (12, 34) verbessert; und
die ersten vorbestimmten Stellen und zweiten vorbestimmten Stellen auf gegenüberliegenden Oberflächen des Halbleitersubstrats (10, 30) vorhanden sind.

2. Verfahren nach Anspruch 1, wobei die dielektrische Schicht (12, 34) bei einer Temperatur unter 500°C aufgetragen wird.

3. Verfahren nach einem der vorstehenden Ansprüche, wobei das Aufbringen der dielektrischen Schicht (12, 34) an den ersten vorbestimmten Stellen das Aufbringen der dielektrischen Schicht durch chemische Dampfabscheidung, Atomlagenabscheidung, pyrolytische Beschichtung, Rotationsbeschichtung, Sprühbeschichtung oder Tauchbeschichtung umfasst.

4. Verfahren nach einem der vorstehenden Ansprüche, wobei die dotierte Epitaxialschicht (13, 33) eine Emitterzone, eine Back Surface Field Zone und/oder eine Front Surface Field Zone der Solarzelle (100, 200) bildet.

5. Verfahren nach einem der vorstehenden Ansprüche, wobei das Aufbringen der dielektrischen Schicht (12, 34) an den ersten vorbestimmten Stellen das Aufbringen der dielektrischen Schicht an den ersten vorbestimmten Stellen und an den zweiten vorbestimmten Stellen umfasst, gefolgt von dem Entfernen der dielektrischen Schicht von den zweiten vorbestimmten Stellen.

6. Das Verfahren nach einem der vorstehenden Ansprüche, wobei die Züchtung der dotierten Epitaxialschicht (13, 33) an den zweiten vorbestimmten Stellen in einem System erfolgt, bei dem beide Halbleitersubstratflächen Vorläuferstoffen ausgesetzt sind, die während der epitaxialen Züchtung verwendet werden.

## Revendications

1. Procédé de fabrication d'une cellule photovoltaïque à semiconducteurs cristalline (100, 200), le procédé comprenant :
déposer une couche diélectrique (12, 34) à des premiers emplacements prédéterminés sur une surface d'un substrat semiconducteur (10, 30), dans lequel la couche diélectrique (12, 34) comprend de l'oxyde de silicium, du nitrure de silicium, du carbure de silicium, de l'oxynitrure ou de l'oxyde de titanium ; et
faire croître ensuite une couche épitaxiale dopée (13, 33) à des seconds emplacements prédéterminés sur une surface du substrat semiconducteur (10, 30) les seconds emplacements prédéterminés étant différents de et non chevauchant avec les premiers emplacements prédéterminés,
dans lequel la couche diélectrique (12, 34) reste sur la surface du substrat semiconducteur durant la fabrication de la cellule photovoltaïque (100, 200) et est maintenue en tant que couche de passivation de surface de la cellule photovoltaïque à semiconducteurs cristalline (100, 200),
**caractérisé en ce que**
faire croître la couche épitaxiale dopée (13, 33) est effectué à une température dans la plage entre 600°C et 1000°C ;
faire croître la couche épitaxiale dopée (13, 33) améliore ainsi une qualité de passivation de surface de la couche diélectrique (12, 34) ; et
des premiers emplacements prédéterminés et des seconds emplacements prédéterminés sont présents sur des surfaces opposées du substrat semiconducteur (10, 30).

2. Procédé selon la revendication 1 dans lequel la couche diélectrique (12, 34) est déposée à une température inférieure à 500°C.

3. Procédé selon l'une quelconque des revendications précédentes dans lequel déposer la couche diélectrique (12, 34) aux premiers emplacements prédéterminés comprend déposer la couche diélectrique par Dépôt Chimique en phase Vapeur, Dépôt de couches Atomiques, revêtement pyrolytique, enduction centrifuge, revêtement par pulvérisation ou revêtement au trempé.

4. Procédé selon l'une quelconque des revendications précédentes dans lequel la couche épitaxiale dopée (13, 33) forme une région émettrice, une région de champ surfacique arrière et/ou une région de champ surfacique avant de la cellule photovoltaïque (100, 200).

5. Procédé selon l'une quelconque des revendications précédentes dans lequel déposer la couche diélectrique (12, 34) aux premiers emplacements prédéterminés comprend déposer la couche diélectrique aux premiers emplacements prédéterminés et aux seconds emplacements prédéterminés, suivi de retirer la couche diélectrique des seconds emplacements prédéterminés.

6. Procédé selon l'une quelconque des revendications précédentes dans lequel faire croître la couche épitaxiale dopée (13, 33) aux seconds emplacements prédéterminés est effectué dans un système dans lequel les deux surfaces du substrat semiconducteur sont exposées à des précurseurs utilisés pendant la croissance épitaxiale.
